## Europäisches Patentamt

## European Patent Office

## Office européen des brevets

(19)

(11) Veröffentlichungsnummer: **0 012 217**
**B1**

(12) **EUROPÄISCHE PATENTSCHRIFT**

(45) Veröffentlichungstag der Patentschrift:
09.02.83

(51) Int. Cl.³: **H 01 L 31/06**

(21) Anmeldenummer: **79104340.9**

(22) Anmeldetag: **06.11.79**

(54) Schichtvorrichtung zur Umwandlung optischer Energie.

(30) Priorität: **13.12.78 US 968887**

(43) Veröffentlichungstag der Anmeldung:
**25.06.80 Patentblatt 80/13**

(45) Bekanntmachung des Hinweises auf die Patenterteilung:
**09.02.83 Patentblatt 83/6**

(84) Benannte Vertragsstaaten:
**DE FR GB**

(56) Entgegenhaltungen:
**DE-A-2 620 115**
**DE-A-2 737 847**
**DE-A-2 814 541**
**US-A-3 426 212**
**US-A-3 591 420**
**US-A-4 096 387**
**US-A-4 127 425**
**US-A-4 155 371**

(73) Patentinhaber: **International Business Machines Corporation, Armonk, N.Y. 10504 (US)**

(72) Erfinder: **Hodgson, Rodney Trevor, 336 Cherry Street, Bedford Hills, N.Y. 10507 (US)**
Erfinder: **Hovel, Harold John, Diane Court, Katonah, N.Y. 10598 (US)**
Erfinder: **Woodall, Jerry Mac Pherson, 336 Cherry Street, Bedford Hills, N.Y. 10507 (US)**

(74) Vertreter: **Rudack, Günter O., Dipl.-Ing., c/o International Business Machines Corporation Zurich Patent Operations Säumerstrasse 4, CH-8803 Rüschlikon (CH)**

## Schichtvorrichtung zur Umwandlung optischer Energie

Das technische Gebiet der Erfindung ist das der Umwandlung optischer Energie, wobei Lichtenergie in elektrische Energie umgewandelt wird. In Halbleiterstrukturen wird, durch Elektron-Loch-Paarbildung und ihre elektrische Empfänglichkeit gegenüber Ladungsträgern, Strahlung mit breitem Spektrum, beispielsweise Sonnenlicht, in elektrische Energie umgewandelt. Die Mehrzahl solcher Halbleiterstrukturen reagiert auf Lichtfrequenzen in einem viel schmaleren Bereich als dem verfügbaren Spektrum des Sonnenlichtes. Eine Halbleitervorrichtung kann deshalb ein breites Lichtspektrum nicht wirksam genug ausnutzen.

Es gibt eine Reihe von Anordnungen, bei denen Halbleitervorrichtungen mit einem pn-Übergang durch ein Substrat gestützt werden und wobei ein Schutzüberzug vorgesehen ist. In manchen Fällen dient dieser nicht nur zum Schutz, sondern auch als Strahlungswandler, um aus dem breiten Spektrum des einfallenden Lichtes Strahlung mit für die Vorrichtung nicht auswertbaren Frequenzen in Strahlung im Arbeitsbereich der Vorrichtung zu verwandeln. Gewöhnlich bestehen solche Schutzschichten über der Sonnenzelle aus einem Bindemittel, das fluoreszentes Material enthält.

Beispielhaft für Anordnungen der genannten Art gemäß dem ersten Teil des Anspruchs 1 ist die in der US-Patentschrift 3 591 420 beschriebene Schichtstruktur, bei der auf einem als Sonnenzelle wirksamen Halbleiterkörper über einem bandbegrenzenden Interferenzfilter eine mit Seltenen Erden dotierte Glasschicht aufgebracht ist, die unter anderem eine stützende Funktion hat.

Abgesehen davon, daß die Bandbegrenzung gemäß der Lehre der genannten US-Patentschrift unerwünscht ist, weil mit Energieverlust behaftet, weisen die bekannten Anordnungen den Nachteil auf, an den Grenzflächen zwischen den einzelnen Schichten durch unterschiedliche Kristallgitter der verwendeten Materialien weitere Einbußen an Wirkungsgrad und mechanischer Stabilität zu erleiden.

Die vorliegende Erfindung schafft hier Abhilfe, indem sie einerseits eine Ausgleichsschicht zwischen der stützenden Schicht und dem aktiven Gebiet vorsieht, wobei die betroffenen Grenzflächen eine besondere Ausgestaltung erfahren können, und andererseits eine besonders vorteilhafte Materialwahl trifft.

Die Vorrichtung nach der Erfindung ist durch die in den Patentansprüchen genannten Merkmale gekennzeichnet.

Fig. 1 stellt eine konventionelle Schichtvorrichtung zur Umwandlung optischer Energie mit einer Strahlungswandlungsschicht dar;

Fig. 2 ist eine erfindungsgemäße Schichtvorrichtung zur Umwandlung optischer Energie mit einer kristallinen Ausgleichsschicht zwischen dem als Strahlungswandler wirksamen Substrat und dem als Photoelement wirksamen aktiven Gebiet;

Fig. 3 ist eine erfindungsgemäße Schichtvorrichtung zur Umwandlung optischer Energie mit einer reflexmindernden Ausbildung der Grenzschicht des aktiven Gebietes.

Es ist ein durchscheinendes Stützglied vorgesehen, das für das einfallende Licht als Strahlungswandler wirksam ist. Ein Teil des Spektrums, der außerhalb des für die Energieumwandlung günstigen Bereiches liegt, wird in der Frequenz zu günstigen Werten hin verschoben. In photoelektrischen Vorrichtungen ist gewöhnlich die aktive Halbleiterschicht sehr dünn, weshalb ein Stützglied notwendig ist. Ein die Frequenz der Strahlung verschiebendes Material kann gleichzeitig auch als durchscheinendes Stützglied dienen.

Ein besonders günstiges Material für ein als Strahlungswandler wirksames Substrat ist mit dreiwertigem Chrom dotiertes Aluminiumoxyd ($Al_2O_3 : Cr^{+3}$), das unter Namen Rubin bekannt ist.

Es ist weiter vorteilhaft, eine kristalline Ausgleichsschicht zwischen dem Stützglied und dem aktiven Gebiet einzuführen, um den Wirkungsgrad des aktiven Bereiches zu erhöhen. Mögliche mechanische Spannungen zwischen den benachbarten Gebieten der aktiven Halbleiterschicht und der stützenden Strahlungswandlungsschicht werden dadurch abgebaut. Reflexmindernde Eigenschaften der Schicht werden dadurch verbessert, indem man die Grenzschichten der benachbarten Gebiete miteinander verzahnt ausbildet.

Zur Herstellung der Schichtvorrichtung wird ein Substrat aus Rubin an einer Oberfläche sägeartig aufgerauht. Dann wird auf dieser gefurchten oder aufgerauhten Oberfläche die kristalline Ausgleichsschicht aus Aluminiumarsenid (AlAs) oder Gallium-Aluminiumarsenid (GaAlAs) aufgewachsen. Schließlich wird eine aktive Halbleiterschicht aus Galliumarsenid (GaAs) auf der kristallinen Ausgleichsschicht aufgewachsen.

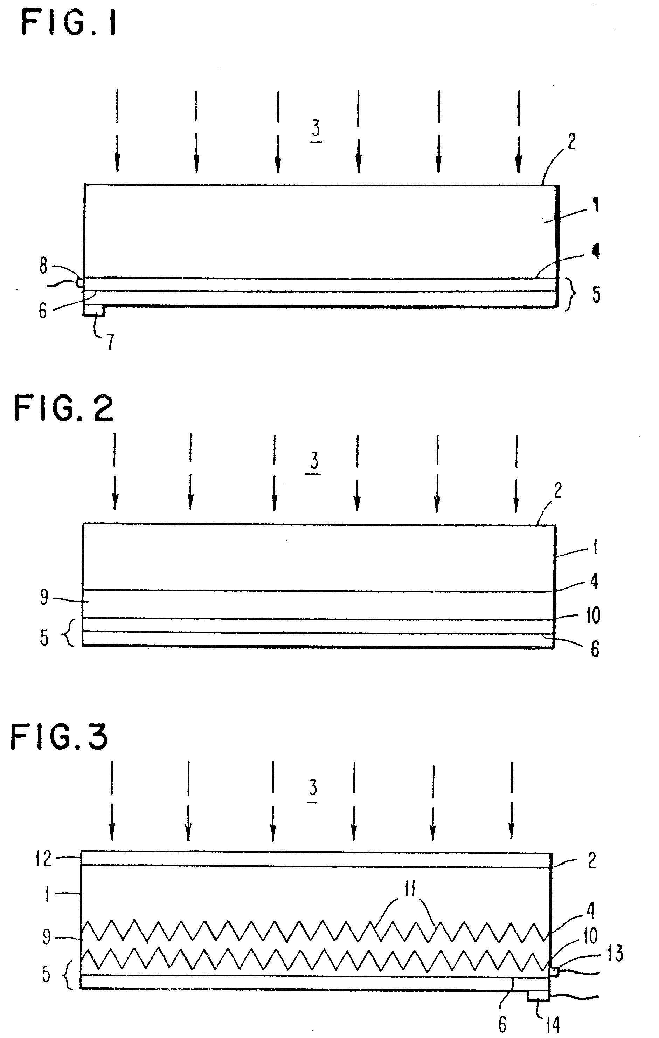

In der Fig. 1 ist eine konventionelle Schichtvorrichtung zur Umwandlung optischer Energie mit einem durchscheinenden Stützglied 1 dargestellt, das ebenso als Strahlungswandler oder als ein die Frequenz der Strahlung verschiebendes Gebiet wirkt. Dieses Substrat 1 hat eine Oberfläche 2, durch die das einfallende Licht 3 eindringt, und eine Grenzschicht 4 als Übergang zu dem benachbarten aktiven Gebiet 5. Das Gebiet 5 ist befähigt, die einfallende optische Energie in elektrische Energie umzuwandeln. Diese Fähigkeit ist in der Figur als pn-Übergang 6 dargestellt. Das elektrische Signal oder die elektrische Spannung erscheint über den Elektroden 7 und 8. Das Gebiet 1 dient sowohl als Substrat für das aktive Gebiet 5 als auch als Strahlungswandler, um einen Teil des breiten Spektrums von einfallendem Licht 3 in Strahlung anderer Frequenz umzuwandeln, für welche das benutzte Halbleitermaterial und der pn-Übergang 6 empfindlich sind.

Die Erfindung wird in Verbindung mit speziellen Materialien für die strahlungswandelnde Stützschicht und die aktive Halbleiterschicht beschrieben. Es wird jedoch aus dem beschriebenen Grundgedanken der Erfindung klar, daß auch andere Materialien für Substrat, Halbleitermaterialien und deren Dotierung verwendet werden können. Weiter kann der Halbleiter amorph, polykristallin oder ein Einkristall sein. Auch der Übergang kann ein einfacher pn-Übergang sein, ein hetero-Übergang zwischen verschiedenen Halbleitern oder ein Schottky-Kontakt, das heißt ein Metall-Halbleiter-Übergang.

Als geeignetes Material für das Substrat hat sich beispielsweise Rubin erwiesen. Das ist mit dreiwertigem Chrom ($Cr^{+3}$) dotiertes Aluminiumoxyd ($Al_2O_3$). Rubin fluoresziert, wenn er mit Licht höherer Frequenzen bestrahlt wird. Er verwandelt auf diese Weise Licht höherer Frequenzen in Licht mit niedereren Frequenzen, die für die Verarbeitung in einem Photoelement brauchbarer sind, weil sie in den Empfindlichkeitsbereich solcher Anordnungen fallen. Andere Materialien mit anderen Dotierungen können gewählt werden, um andere Frequenzverschiebungen der einfallenden Strahlung zu bewirken. Der geeignete Strahlungswandler muß entsprechend der einfallenden Strahlung und der Empfindlichkeit des Photoelementes gewählt werden.

Wenn das aktive Gebiet 5, welches den pn-Übergang 6 enthält, beispielsweise aus Galliumarsenid (GaAs) besteht, dann absorbiert die Chromdotierung des Rubin einfallendes Licht 3 mit Wellenlängen kleiner als 600 nm. Die in das Gitter des Aluminiumoxyds eingebauten Chromionen haben eine Konzentration von 0,2% bis 2%, vorzugsweise 0,7%. Das durchscheinende Stützglied 1 besteht aus Rubin und wirkt sowohl als Strahlungswandler als auch als Substrat. Diese Absorption bewirkt eine Verschiebung von Strahlung mit Wellenlängen im Bereich von 380 bis 450 nm und von 500 bis 600 nm zu etwa 50% in Strahlung der Wellenlänge 694.3 nm und den Rest von etwa 50% in den Wellenlängenbereich von 700 bis 800 nm. Der pn-Übergang 6 in dem aktiven Gebiet 5 ist etwa 1 μm von der Grenzschicht 4 entfernt, damit die Strahlung weit genug eindringen kann, so daß möglichst wenig Rekombination der erzeugten Elektron-Loch-Paare erfolgt. Bekanntlich begrenzen die Verluste durch Rekombination an der Oberfläche den Wirkungsgrad konventioneller Sonnenzellen mit einem pn-Übergang aus Galliumarsenid.

Die Fig. 2 zeigt eine erfindungsgemäß verbesserte Struktur der Schichtvorrichtung nach Fig. 1. Bei der Herstellung läßt man die Halbleiterschicht des aktiven Gebietes auf einem Substrat aufwachsen. In einer Anordnung, wo das Substrat das durchscheinende Stützglied ist, durch welches die einfallende Strahlung dringt, wird das aktive Gebiet auf dem Substrat so aufgewachsen, daß der pn-Übergang sich ziemlich nahe der Grenze der beiden benachbarten Schichten befindet. Verschiedentlich passen jedoch die Gitterkonstanten der benachbarten Gebiete schlecht zueinander. Um diesen Nachteil auszugleichen, wird gemäß der Erfindung zwischen dem Stützglied 1 und dem aktiven Gebiet 5 eine kristalline Ausgleichsschicht 9 vorgesehen.

Das einfallende Licht 3 durchdringt die Oberfläche 2 und fällt in das durchscheinende Stützglied 1 ein. Dort wird ein Teil der einfallenden Strahlung in Strahlung eines Frequenzbereiches umgewandelt, der besser in den Empfindlichkeitsbereich des aktiven Gebietes 5 fällt. Die Ausgleichsschicht 9 hat zweckmäßig eine Gitterkonstante zwischen der des Aluminiumoxyds und der Gitterkonstanten des aktiven Gebietes 5. Sie ist daher epitaktisch sowohl mit der Zwischenschicht 4 des Strahlungswandlungsgebietes als auch mit der Grenzschicht 10 des aktiven Gebietes 5.

Wenn man Galliumarsenid oder andere Halbleiter für das aktive Gebiet auf dem Rubinsubstrat 1 aufwachsen läßt, enthalten die ersten μm des Materials des aktiven Gebietes 5 eine große Anzahl von Gitterfehlern, die eine Herabsetzung des Wirkungsgrades der Sonnenzelle bewirken. Dies könnte teilweise dadurch verbessert werden, daß man das Gebiet 5 zu einer Dicke von etwa 10 μm oder mehr aufwachsen läßt und so den pn-Übergang 6 von der Grenzschicht weiter entfernt erzeugt. Aber ein größerer Abstand von der Grenzschicht beeinflußt den Wirkungsgrad ebenfalls ungünstig.

Auf der Grenzschicht 4 wird eine die Gitterfehler verringernde Ausgleichsschicht oder kristalline Ausgleichsschicht 9 epitaktisch aus einem Material aufgewachsen, das einen mittleren Atomabstand oder eine Gitterkonstante nahe der des Materials in dem aktiven Gebiet 5 hat. Diese Ausgleichsschicht 9 sollte die Strahlung möglichst wenig dämpfen. Sie sollte durchsichtig für Licht sein, das durch das Stützglied 1 durchgelassen wird und das Frequenzen im Bereich der Empfindlichkeit des aktiven Gebietes 5 hat. Auch sollte die Schicht Fluoreszenzlicht aus dem Gebiet 1 durchlassen. Auf der Grenzschicht 10 der Ausgleichsschicht 9 kann dann das aktive Gebiet 5 aufgewachsen werden. Die Dicke der kristallinen Ausgleichsschicht 9 liegt vorzugsweise zwischen 5 und 10 μm.

Bei der Schichtanordnung gemäß der Fig. 2, wo das Aluminiumoxyd des Gebietes 1 mit dreiwertigem Chrom dotiert ist, mag die Ausgleichsschicht 9 aus Aluminiumarsenid (AlAs) oder aus Gallium-Aluminiumarsenid ($Ga_{1-x}Al_xAs$) bestehen, wobei x gleich oder größer als 40% ist ($x \geq 40\%$). Über dieser Schicht wird das aktive Gebiet 5 aufgewachsen, eine 1 bis 2 μm dicke Schicht aus Galliumarsenid (GaAs).

Die Anteile des Lichtes 3 mit höherer Frequenz, die normalerweise mit keinem oder nur geringem Photoeffekt absorbiert würden, werden jetzt durch den Rubin zu Strahlung mit niedrigeren Frequenzen gewandelt, wenn das Licht das Stützglied 1 aus mit dreiwertigem Chrom dotiertem Aluminiumoxyd ($Al_2O_3 : Cr^{+3}$) durchdringt. Da die kristalline Ausgleichsschicht 9 für das Fluoreszenzlicht und für das Licht mit niedrigeren Frequenzen als jenes Licht, das in dem Rubin absorbiert wird, transparent ist, durchdringt das Licht das Gebiet 9 und dringt in das aktive Gebiet 5 ein. Die Grenze zwischen der kristallinen Ausgleichsschicht 9 aus Gallium-Aluminiumarsenid ($Ga_{1-x}Al_xAs$) und dem aktiven Gebiet 5 aus Galliumarsenid (GaAs) bildet einen Bereich, wo Oberflächenrekombination nur langsam erfolgt. Mögliche Gitterdefekte befinden sich meistens in der Ausgleichsschicht 9, was so ermöglicht, daß das aktive Halbleitergebiet 5 aus Galliumarsenid von wesentlich besserer Qualität ist, als wenn es direkt auf dem Aluminiumoxyd aufgewachsen wäre.

Bei der Herstellung der Ausgleichsschicht erzielt man einen Kostenvorteil, wenn man den Wert x in der Formel $Ga_{1-x}Al_xAs$ so hoch als möglich macht. Das bedeutet, daß man zweckmäßig so wenig Gallium als möglich verwendet.

Wenn die kristalline Ausgleichsschicht 9 aus Aluminiumarsenid oder aus Gallium-Aluminiumarsenid besteht, erzielt man einen kleineren Brechungsindex im Vergleich zur aktiven Halbleiterschicht 5 aus Galliumarsenid. Brechungsverluste an der Grenze zwischen beiden Gebieten werden so verringert.

Gemäß der Fig. 3 kann man die reflexmindernden Eigenschaften der Schichtanordnung verbessern, indem man die der kristallinen Ausgleichsschicht 9 zugewandte Oberfläche der strahlungswandelnden Stützschicht 1 mit Mikrorillen oder Verzahnungen 11 versieht, bevor man darauf die Ausgleichsschicht 9 aufwächst. Das einfallende Licht wird so in Vielfachreflexionen eingefangen. Die dem einfallenden Licht 3 zugewandte Oberfläche 2 der Rubinschicht ist mit einem reflexmindernden Belag 12 versehen. Dieser Belag kann beispielsweise aus Magnesiumfluorid ($MgF_2$) mit einer Schichtdicke von etwa 100 nm bestehen. Das einfallende Licht 3 durchdringt den Belag 12 und die Oberfläche 2. Ein Teil des Spektrums wird in der Frequenz verändert durch die strahlungswandelnde Eigenschaft der Stützschicht 1, so daß die dem aktiven Gebiet zugeführte Strahlung besser an deren Empfindlichkeit angepaßt ist. Das Licht erzeugt ein elektrisches Signal oder eine elektrische Spannung zwischen den Elektroden 13 und 14. Das Gebiet 1 wird mit den Mikrorillen entweder mechanisch versehen durch Ionenbeschuß oder durch ein anisotropisches chemisches Ätzen. Die Ausgleichsschicht 9 wird dann auf den Mikrorillen 11 von der Grenzschicht 4 bis zur Grenzschicht 10 aufgewachsen und darauf der aktive Bereich 5 gebildet. Die so erzeugte Struktur verbessert außerordentlich den Wirkungsgrad der Schichtvorrichtung zur Umwandlung optischer Energie.

Die üblicherweise für den Photoeffekt unwirksamen höher frequenten Anteile des Lichtes werden mit einem Quantenwirkungsgrad von fast 90% in Strahlung niedrigerer Frequenz umgewandelt. Nur 6% des Fluoreszenzlichtes kann von der Oberfläche 2 des Gebietes 1 entweichen, weil der größte Teil des Fluoreszenzlichtes auf die Oberfläche 2 mit einem größeren als dem Grenzwinkel der Totalreflektion einfällt. So wird das Licht in Richtung auf die Grenzschicht 4 zwischen dem Gebiet 1 und dem Gebiet 9 reflektiert. Weil der Brechungsindex der Ausgleichsschicht 9 größer als der Brechungsindex des Stützgliedes 1 ist, besteht für diese Ausbreitungsrichtung kein Grenzwinkel der Totalreflexion, weshalb der größte Teil des Fluoreszenzlichtes in das aktive Gebiet 5 übertragen wird.

Der strahlungswandelnde Einfluß des Stützgliedes überwiegt bei weitem mögliche Absorptionsverluste im Substrat, die eventuell die Ausgangsleistung schmälern könnten.

## Patentansprüche

1. Schichtvorrichtung zum Umwandeln optischer in elektrische Energie, mit einem als Photoelement wirksamen aktiven Gebiet und mit einem durchscheinenden, als Strahlungswandler wirksamen Stützglied, dadurch gekennzeichnet, daß zwischen dem Stützglied (1) und dem aktiven Gebiet (5) eine die möglichen Unterschiede der Gitterkonstanten der Materialien des Stützgliedes (1) und des aktiven Gebietes (5) mindernde kristalline Ausgleichsschicht (9) vorgesehen ist.

2. Vorrichtung nach Anspruch 1, dadurch gekennzeichnet, daß die Grenzschichten (4, 10) der kristallinen Ausgleichsschicht (9) und der benachbarten Gebiete des Stützgliedes (1) und des aktiven Gebietes (5) miteinander verzahnt ausgebildet sind.

3. Vorrichtung nach Anspruch 1, dadurch gekennzeichnet, daß die kristalline Ausgleichsschicht (9) aus Aluminiumarsenid (AlAs) besteht.

4. Vorrichtung nach Anspruch 1, dadurch gekennzeichnet, daß die kristalline Ausgleichsschicht (9) aus Gallium-Aluminiumarsenid ($Ga_{1-x}Al_xAs$) besteht, wobei der Anteil an Gallium nicht größer als 60% ($x \geq 40\%$) ist.

5. Vorrichtung nach Anspruch 1, dadurch gekennzeichnet, daß das aktive Gebiet (5) einen pn-Übergang in einem Halbleitermaterial enthält.

6. Vorrichtung nach Anspruch 5, dadurch gekennzeichnet, daß das Halbleitermaterial Galliumarsenid (GaAs) ist.

7. Vorrichtung nach Anspruch 1, dadurch gekennzeichnet, daß das Stützglied (1) aus mit dreiwertigem Chrom dotierten Aluminiumoxyd ($Al_2O_3 : Cr^{+3}$) besteht.

8. Vorrichtung nach Anspruch 1, dadurch gekennzeichnet, daß das aktive Gebiet (5) beiderseits des pn-Übergangs (6) mit Elektroden (13, 14) versehen ist.

9. Vorrichtung nach Anspruch 1, dadurch gekennzeichnet, daß die dem einfallenden Licht (3) zugewandte Oberfläche (2) des Stützgliedes (1) mit einem reflexvermindernden Belag (12) versehen ist.

10. Vorrichtung nach Anspruch 9, dadurch gekennzeichnet, daß der reflexvermindernde Belag (12) aus Magnesiumfluorid (MgF2) besteht.

## Claims

1. Laminated device for converting optical energy into electrical energy, with an active region acting as a photo-element and with a translucent support member acting as a radiation converter, characterized in that between the support member (1) and the active region (5) there is provided a crystalline accommodation layer (9) for reducing any possible differences of the lattice constants of the materials forming the support member (1) and the active region, respectively.

2. Device according to claim 1, characterized in that the boundaries (4, 10) of the crystalline accommodation layer (9) and of the neighbouring areas of the support member (1) and of the active region (5) are mutually serrated.

3. Device according to claim 1, characterized in that the crystalline accommodation layer (9) consists of aluminium arsenide (AlAs).

4. Device according to claim 1, characterized in that the crystalline accommodation layer (9) consists of gallium aluminium arsenide ($Ga_{1-x}Al_xAs$) wherein the gallium content is not greater than 60% ($x \geq 40\%$).

5. Device according to claim 1, characterized in that the active region (5) comprises a p-n junction within a semiconductor material.

6. Device according to claim 5, characterized in that the semiconductor material is gallium arsenide (GaAs).

7. Device according to claim 1, characterized in that the support member (1) consists of aluminium oxide doped with tri-valent chromium ($Al_2O_3 : Cr^{+3}$).

8. Device according to claim 1, characterized in that the active region (5) is provided with electrodes (13, 14) on both sides of the p-n junction (6).

9. Device according to claim 1, characterized in that the surface (2) of the support member (1) exposed to incident light is coated with a reflection-reducing layer (12).

10. Device according to claim 9, characterized in that the reflectionreducing layer (12) consists of magnesium fluoride (MgF2).

## Revendications

1. Dispositif stratifié pour la conversion d'énergie optique en énergie électrique, comportant une région active servant de photo-élément et un élément de support translucide servant de convertisseur de radiation, caractérisé en ce que, entre l'élément de support (1) et la région active (5) est formé une couche de compensation cristalline (9) réduisant les différences éventuelles des constantes de réseaux des matériaux utilisés pour l'élément de support (1) et pour la région active (5).

2. Dispositif selon la revendication 1, caractérisé en ce que les couches limites (4, 10) de la couche de compensation cirstalline (9) et des régions avoisinantes de l'élément de support (1) et de la région active (5) sont dentelées.

3. Dispositif selon la revendication 1, caractérisé en ce que la couche de compensation cristalline (9) est composée d'arséniure aluminium (AlAs).

4. Dispositif selon la revendication 1, caractérisé en ce que la couche de compensation cristalline (9) est composée d'arséniure de gallium-aluminium ($Ga_{1-x}Al_xAs$), la teneur en gallium n'étant pas supérieure à 60% ($x \geq 40\%$).

5. Dispositif selon la revendication 1, caractérisé en ce que la région active (5) comporte une jonction p-n dans un matériau semi-conducteur.

6. Dispositif selon la revendication 5, caractérisé en ce que le matériau semiconducteur est de l'arséniure de gallium (GaAs).

7. Dispositif selon la revendication 1, caractérisé en ce que l'élément de support (1) est composé d'oxyde d'aluminium dopé avec du chrome trivalent ($Al_2O_3 : Cr^{+3}$).

8. Dispositif selon la revendication 1, caractérisé en ce que la région active (5) comporte des deux côtés de la jonction p-n (6) des électrodes (13, 14).

9. Dispositif selon la revendication 1, caractérisé en ce que la surface (2) de l'élément de support (1), faisant face à la lumière incidente (3), comporte une couche (12) diminuant la réflexion.

10. Dispositif selon la revendication 9, caractérisé en ce que la couche (12) diminuant la réflexion est composée de fluorure de magnésium (MgF2).

**FIG. 1**

$\underline{3}$

2

1

8

4

6

5

7

**FIG. 2**

$\underline{3}$

2

1

9

4

10

5

6

**FIG. 3**

$\underline{3}$

12

2

1

11

9

4

10

13

5

6

14